# EUROPEAN PATENT SPECIFICATION

(11) **EP 3 465 779 B1**
(45) Date of publication and mention of the grant of the patent: **02.10.2019**
(21) Application number: 17727885.0
(22) Date of filing: 05.06.2017
(51) Int. Cl.: H01L 33/48, H01L 33/62

(54) **SOLID STATE UV LIGHT OUTPUT DEVICE**
FESTKÖRPER-UV-LICHT-EMITTIERENDE VORRICHTUNG
DISPOSITIF ÉMETTEUR DE LUMIÈRE UV À L'ÉTAT SOLIDE

(30) Priority: 07.06.2016 EP 16173215
(43) Date of publication of application: 10.04.2019
(73) Proprietor: Signify Holding B.V., 5656 AE Eindhoven (NL)
(72) Inventor: DE SAMBER, Marc, Andre, 5656 AE Eindhoven (NL); HOVESTAD, Arie, Jan, 5656 AE Eindhoven (NL)
(74) Representative: Verweij, Petronella Daniëlle
(86) International application number: PCT/EP2017/063632
(87) International publication number: WO 2017/211773

(56) References cited:
- JP-A- 2001 096 795
- JP-A- 2007 324 303
- JP-A- 2013 168 509
- US-A1- 2004 070 014
- US-B1- 6 243 259

## Description

### FIELD OF THE INVENTION

This invention relates to solid state UV output devices.

### BACKGROUND OF THE INVENTION

The use of UV light - in particular UV-C light - for the purification of water, or more precisely the disinfection and sterilization of water, (hereafter referred to, for the sake of simplicity, as water purification or purification of water) is a well-known and well established technical practice. UV-C light at sufficiently short wavelengths is mutagenic to bacteria, viruses and other micro-organisms. At a wavelength of around 265 nm, UV breaks molecular bonds of DNA in the cells of micro-organisms, producing thymine dimers in the DNA, thereby destroying the DNA structure necessary to reproduce the cell, rendering them harmless or prohibiting growth and reproduction.

More recently, demand has grown for UV-C water purification devices which can utilize technologies from the fast developing field of UV-C LED light sources. It is well known, for example, that semiconductor materials of group IIIA-nitrides:

Al*ₓ*Ga_{1-*x*-*y*}In*_{y}*N, [0 </ = *x*+*y <*/= 1]

have direct band gaps that can be used to generate electromagnetic radiation in the wavelength of ultraviolet (UV). For instance, (Al*ₓ*Ga_{1-*x*}N (0 < *x* < 1)) is often utilized as the component for a light emitting diode (LED), generating UV radiation below 365nm.

In terms of the above mentioned water purification technology, UV-C LED solutions confer numerous advantages over more traditional fluorescent or incandescent UV-C lamps, including for example fast switching capability, small form factor, long lifetime, and a significantly 'cleaner' material composition - comprising few hazardous or harmful component materials.

Typical UV-C LED packages or modules use a glass (quartz glass, sapphire or fused silica) window transparent or translucent to UV-C, which is attached to a ceramic cavity. The UV-C LED packages are delivered as a chip or packaged solid state die, and make use of packaging and assembly technologies known from the electronics industry (and more specifically from power electronics). In this way, standardized and mass exploited assembly and interconnection technologies and platforms are available. The integration of various electrical functions (e.g. drivers) can easily be done at low cost, within the form factor volume of an LED module.

One key aspect in the design of a solid state UV module is the thermal management. In particular, thermal coupling between the UV module and other circuit elements presents thermal management issues.

There is therefore a need for a package design for a UV solid state output device which provides enhanced thermal management.

Each documents JP 2007 324303 A, JP 2001 096795 A, JP 2013 168509 A and US 2004/070014 A1, describes an optoelectronic package where the light emitting element is attached on the inside of a transparent lid.

Document US 6 243 259 B1 discloses the use of a spring electrical contact in an optoelectronic package.

### SUMMARY OF THE INVENTION

The invention is defined by the claims.

According to an aspect of the invention, there is provided a solid state UV output device package, comprising:
a base comprising a chamber;
electrical components within the chamber;
at least two spring contacts mounted in the chamber; and
a lid,
wherein the lid comprises:
   a UV transparent or translucent window;
   electrical connection tracks mounted over the inside of the window; and
   a solid state UV output device mounted over the electrical connection tracks,
wherein the lid is mounted over the base to close the chamber, with the electrical connection tracks making electrical contact with the spring contacts, and wherein the solid state UV output device and the electrical components are provided on different levels.

This package has an architecture which provides efficient thermal management of a solid state UV module. The UV module and the associated electrical/electronic circuits are provided on different levels, so that the overall three dimensional shape of the package is designed for effective thermal dissipation. The multi-level design provides thermal partitioning between the dissipating UV module and the associated driver or other electronics. The lid is for example intended to be contacted (on the side outside the chamber) with water, and this water is used as an ultimate thermal heat sink. Note that the "electrical components" may be electrical (i.e. passive) and/or electronic (i.e. semiconductor).

The different elements may all be implemented using known mature technologies giving a low cost solution.

The solid state UV output device for example comprises a UV LED arrangement. It may comprise one or more UV-C LEDs, but UV-A and UV-B may also be used. These devices are becoming of increasing interest, for example for water purification.

A UV reflecting material may be provided in the chamber. The UV arrangement may direct its output downwardly (i.e. away from the transparent or translucent window of the lid) and the reflector then redirects the light to pass through the window towards a target for the UV radiation.

The UV reflecting material may form a focusing mirror shape within the chamber. This provides beam shaping and/or steering.

The base for example comprises a printed circuit board on which at least some of the electrical components are mounted. The spring contacts may then be mounted on the printed circuit board, for making electrical connection between the UV LED and the other components carried by the printed circuit board.

The base may comprise side walls formed of anodized aluminum. These provide good thermal conductivity to the outside as well as having chemical passivation. Other materials may of course be used.

There may be thermal coupling elements between the base and the lid. The spring contacts have as prior function the creation of electrical contacts between the solid state UV output devices and the electronic circuitry, but they also provide a first thermal coupling. The thermal coupling can be improved using these further thermal coupling elements.

The UV transparent or translucent window for example comprises a translucent ceramic.

The package may for example be used in a water purification module for administering UV light to a body of water. The specific use of packages with UV LED based modules for water hygiene applications enables the package to be brought into very close vicinity of the water to be treated, and can even be used inside the water, thereby creating an optimal interaction between the package and the water. This creates a number of possible interface solutions, for thermal performance improvement.

### BRIEF DESCRIPTION OF THE DRAWINGS

Examples of the invention will now be described in detail with reference to the accompanying drawings, in which:
Figure 1 shows an exit window design for use in a UV LED package;
Figure 2 shows an example of the connection tracks used in the exit window;
Figure 3 shows a base for use in a UV LED package;
Figure 4 shows the mounting of the over the base;
Figure 5 shows the completed package;
Figure 6 shows a surface mount spring contact;
Figure 7 shows a through-hole spring contact;
Figure 8 shows a set of the packages used in a water purification device;
Figure 9 shows in simplified form other possible ways to integrate the package into a water vessel.

### DETAILED DESCRIPTION OF THE EMBODIMENTS

The invention provides a solid state UV output device package ("UV module") which comprises a base which defines a chamber in which electrical components are housed, for example including a UV device driver circuit. At least two spring contacts are mounted in the chamber. A lid over the chamber has a UV transparent or translucent window, electrical connection tracks mounted over the window and a solid state UV output device (which may comprise one or more UV sources) mounted over the electrical connection tracks. The electrical connection tracks of the lid make electrical contact with the spring contacts. This provides a two-layer structure which provides improved thermal management.

Use of UV light - in particular UV-C light - for the sterilization of water is well known. UV light at sufficiently short wavelengths is mutagenic to bacteria, viruses and other micro-organisms. At a wavelength of 2,537 Angstroms (254 nm), UV breaks molecular bonds within micro-organismal DNA, producing thymine dimers in the DNA, thereby destroying the organisms, rendering them harmless or prohibiting growth and reproduction. Ultraviolet disinfection of water consists of a purely physical, chemical-free process. UV-C radiation attacks the vital DNA of the bacteria directly. The bacteria lose their reproductive capability and are destroyed. Even parasites such as cryptosporidia or giardia, which are extremely resistant to chemical disinfectants, are efficiently reduced.

Most typically, germicidal ultraviolet light is delivered by a mercury-vapor lamp, which emits UV light at the germicidal wavelength (mercury vapor emits at 254nm). Known UV units for water treatment generally consist of a specialized low pressure mercury vapor lamp that produces ultraviolet radiation at 254nm, or medium pressure UV lamps that produce a polychromatic output from 200nm to visible and infrared frequencies. Medium pressure lamps are approximately 12% efficient, whilst amalgam low-pressure lamps can be up to 40% efficient. The UV lamp never directly contacts the water, but is housed inside a glass quartz sleeve, submerged in the water, or else mounted external to the water.

Due to the large form factor, inflexible operating mode, and hazardous compositional materials, increasingly attention has turned toward the use of solid state UV-emitting devices, such as UV LEDs within water purification devices. It is well known that group IIIA-nitrides

(Al*ₓ*Ga_{1-*x*-*y*}In*_{y}*N, [0 </ = *x*+*y* </= 1])

have direct band gaps which can be used to generate electromagnetic radiation in the ultraviolet wavelength range.

The invention relates to a UV output device package design. The invention will be described with reference to a UV LED implementation.

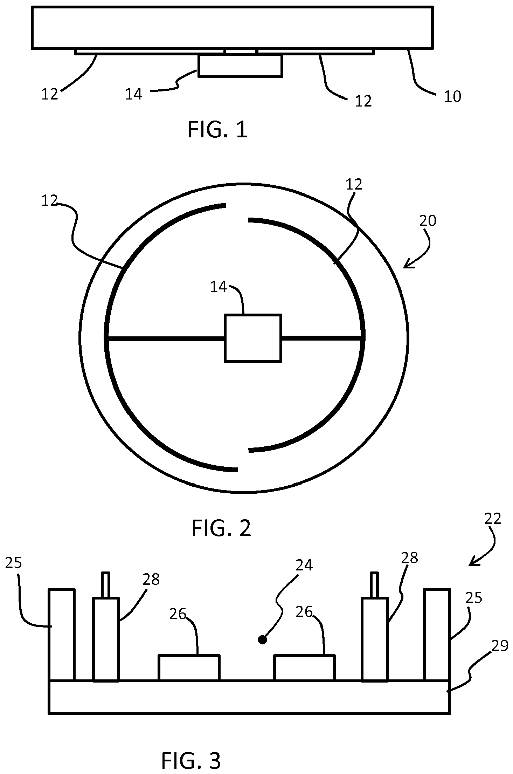

Figure 1 shows exit window design for use in the package. The exit window is in the form of a UV transparent or translucent window 10. Electrical connection tracks 12 are mounted over the window and a UV LED arrangement 14 is mounted over the electrical connection tracks. The connection tracks make electrical connection with the anode and cathode of the UV LED arrangement. The UV LED arrangement may comprise one or more LEDs for example within a surface mount device. For example, the UV LED arrangement has bottom contacts which are soldered over the connection tracks 12. Thus, the LED arrangement may be a packaged component, but it may comprise one or more bare LED dies. In the example shown, the UV LED arrangement emits light downwards, away from the exit window output surface.

The exit window may be translucent, which has the effect of increasing the effective size of the optical source. The light scatters in the translucent material. Absorption of light is avoided thus preventing energy loss to heating.

The exit window may, by way of non-limiting example, be composed of Polycrystalline Alumina (PCA) materials, such as for example Spinel (MgAl₂O₄), AlON, or sapphire. However, other suitable translucent ceramic materials may also be used.

The exit window may instead be transparent to the UV output.

Various optical properties may be used, including a transparent exit window, a diffusive exit window and an exit window which includes beam shaping, depending on the application requirements. Lens-shaped windows may be used, or Fresnel-based structures. The exit window may have multiple sections with different optical properties.

Figure 2 shows an example of the connection tracks. In this example, there are two arcuate tracks at different radius over a circular light exit window 10. This means that electrical connection can be made to each track at a range of possible angular orientations. The connection tracks are designed to cover a small area of the exit window so that they do not block light exiting the chamber. The connection tracks may be thin film or thick film metal patterns. The chamber functions as a mixing box for the output of the UV LED arrangement.

The exit window design forms a lid 20 of a package.

Figure 3 shows the base 22 of the package. The base forms a chamber 24 with an outer side wall 25. Electrical components 26 are housed within the chamber, for example including a UV LED driver circuit. The electrical components may define simple driver electronics for ensuring the correct voltage and/or current is supplied to the UV LED arrangement. More complicated driver circuit such as pulse width modulation drivers may be used for improved control of the UV output. Sensors may also be incorporated into the design, for example thermal sensors for thermal management control, or optical sensors for keeping track of the functionality of the UV LED arrangement.

The chamber also houses at least two spring contacts 28. They are mounted at different positions from the center so that one is aligned with one of the arcuate connection tracks and the other is aligned with the other arcuate connection track. In this way, the electrical connection between the base and the lid cannot be made with the wrong polarity. The electrical components and the spring contacts are mounted on a printed circuit board 29, which may form the bottom of the base, or the circuit board may be provided over a further carrier. These electrical components are not necessarily located on the base of the chamber, the circuit board or circuit boards may be located at any other location within the chamber that is at a different level from the base of the UV LED. That is to say, any level which maintains the multi-level design which in turn provides thermal partitioning between the UV LED and the other electrical components. It is not essential to form the bottom of the base 22 with the at least one printed circuit board 29. As stated above, the circuit board 29 may be located over a further carrier which will space the electronic components 26 away from the bottom of the base within the chamber 24.

Of course any other connection track arrangement is possible, including a single pad to which the spring contact is biased.

The lid 20 is mounted over the base 22 to close the chamber, with the electrical connection tracks making electrical contact with the spring contacts.

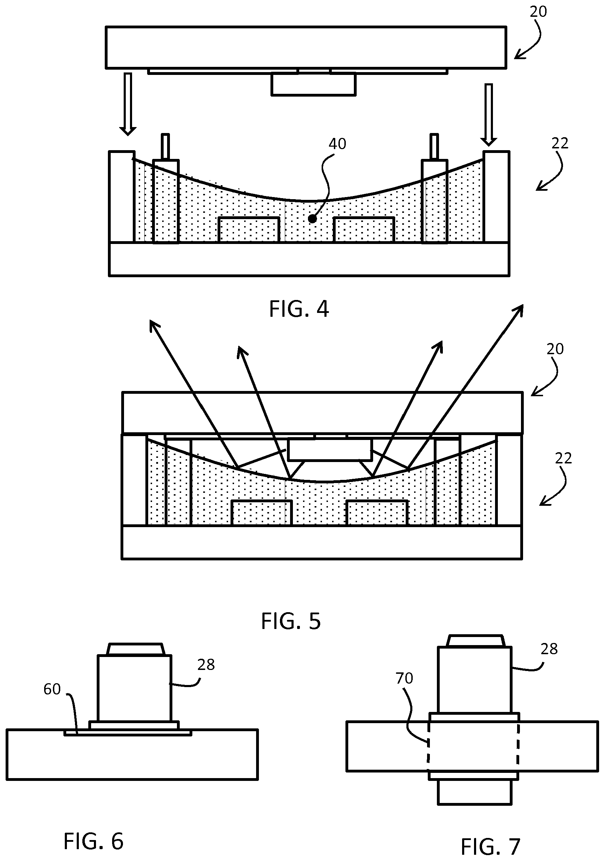

Figure 4 shows the mounting of the lid 20 over the base 22. It additionally shows the chamber being partly filled with a UV reflecting material 40.

The completed package is shown in Figure 5.

The resulting package has a 3D architecture which is designed to optimize the thermal dissipation properties. The UV LED arrangement is mounted on a first level, on the exit window of the package, and for a water purification application, this exit window is in close thermal contact with the water. The rest of the electrical functionality such as the UV LED driver, electrical connections in the package, and external electrical interfaces, are mounted at a second level, the second level may mean that the printed circuit board 29 is located at the bottom of the base 22 or it may be located elsewhere within the chamber 24.

The design of the lid (i.e. the exit window) allows simple electrical contact to the rest of the circuitry, but the optical pathway through the exit window is largely maintained. The interconnection formed between the lid and the base is a vertical interconnection and it is automatically formed during assembly of the base and lid to define the final package.

The package design enables the UV LED arrangement to be in intimate thermal contact with the exit window while the electronics, mechanics and interconnection is accommodated by the base of the package.

The spring contacts are in the form of spring mounted pins, and they give a high degree of tolerance while also not blocking the UV LED arrangement output.

The figures do not show the electrical connections to the outside. These connections may be through-substrate connections, for example implemented in an FR4 or ceramic circuit board, or they may be metallic wires soldered inside the package and fed through drilled holes towards the outside.

The spring contacts are known devices. They are used to form vertical connections between the circuitry in the chamber and the exit window, during the mounting of the two parts together. Suitable spring loaded pins are known in solder mount format, for mounting onto a printed board using standard soldering process, which process is also used for component soldering for the other electrical components.

Different pin types are available, for example with a different pin sharpness, which can be selected for the best match to the electrical requirements of the package, such as the current specification or contact resistance specification, as well as the material that is to be contacted.

The spring contacts may also be used to create a direct external contact if desired. In such a case, through-hole printed circuit boards and through-hole spring loaded pins may be used.

Figure 6 shows a surface mount spring contact 28 soldered to a solder pad 60. Figure 7 shows a through-hole spring contact 28 clamped to both sides of the circuit board and extending through a through-hole 70. There may be some spring contacts which are for internal connections only, and others which provide external contact.

The example of Figures 4 and 5 shows the chamber partially filled with a reflector, such as a dispensed fill material. An example is a formulation of boron nitride particles in silicone as to form a highly reflective and directional UV-C diffuse mirror. This diffuse mirror serves the purpose of optimizing the light recycling in the chamber for maximal optical efficiency.

During the assembly of the package, the spring contacts are spring-loaded so that after assembly the required mechanical and electrical connection is formed. The final mechanical fixation of the package may be based on a mechanical snap fit, for example followed by a post-processing step to further increase the hermetic sealing of the package.

In use of the package, a part of the package is in contact with the water being treated. In general, at least the exit window should make contact with the water to take advantage of the short thermal pathway between the UV LED and the water.

By way of example, a typical size of the package may be a diameter of 1 cm and a module height (external dimensions) of e.g. 3-5 mm. These dimensions are based on realistic thicknesses of the parts (e.g. a printed board, a metal ring, a ceramic window. Depending on the circuitry for the driver electronics the module might have a larger diameter. The power rating (in particular the thermal power to be dissipated to the environment and water) will also impact the size, because a certain contact area is needed for a particular heat transfer requirement.

The design above provides improved dissipation of heat away from the package, but with the two dissipating parts (the base and lid) acting as quasi-separated heat spreaders and heat transfer elements.

The thermal management is of interest because UV-C LEDs are still relatively low in efficiency, and therefore they generate significant amounts of heat. The thermal management solution thus aims to isolate electrical circuitry from the heat generated by the UV LED but at the same time providing a thermal dissipation path both for the heat generated by the UV LED but also to take heat away from the electrical components.

The heat transfer may be improved by using further heat spreading designed into the package. This may be achieved by optimization of the parts and processing.

For example, the material for the side walls 25 of the chamber may be selected to be of a good thermal conducting type, such as aluminum and in particular anodized aluminum to provide chemical passivation.

Furthermore the sides wall 25 may be attached in such a way as to allow good thermal contact between the printed circuit board 29 and the exit window. A solder type connection may be used, using gold-tin or gold-tin-copper soldering. The exit window, the printed board and the side walls may be provided with a solderable finish layer for this purpose.

The top-to-bottom vertical connections formed by the spring contacts 28 may contribute to the heat transfer between top and bottom element. However, additional thermal pins acting as thermal pillars may also be added for heat transfer purposes. Separate electrically isolated landing pads on the printed board and exit window may be provided for the mounting of heat thermal pillars.

Depending on the use case, different combinations of features may be used. The various technology choices, use conditions and setting of the package may also be taken into account. For example the LED junction temperature boundary conditions, the dissipated power in the driver, the form factor (relevant to the power density), and the exit window material type (e.g. sapphire versus quartz), will impact the choice.

The module preferably makes use of electrical and mechanical contacts which are formed with high melting and thermally performing materials such as combinations of metals and Au-Sn solder alloys.

Various other thermal optimization approaches are possible. For example, the electronic circuitry may be kept at the lowest temperature by using thermally isolating layers, and with only the spring pins really creating a thermal pathway. Alternatively, a fully thermally balanced system (with all of the 3D package highly thermally conductive) can be considered for optimal cooling of the overall module.

There are various options for how to integrate the package into a vessel.

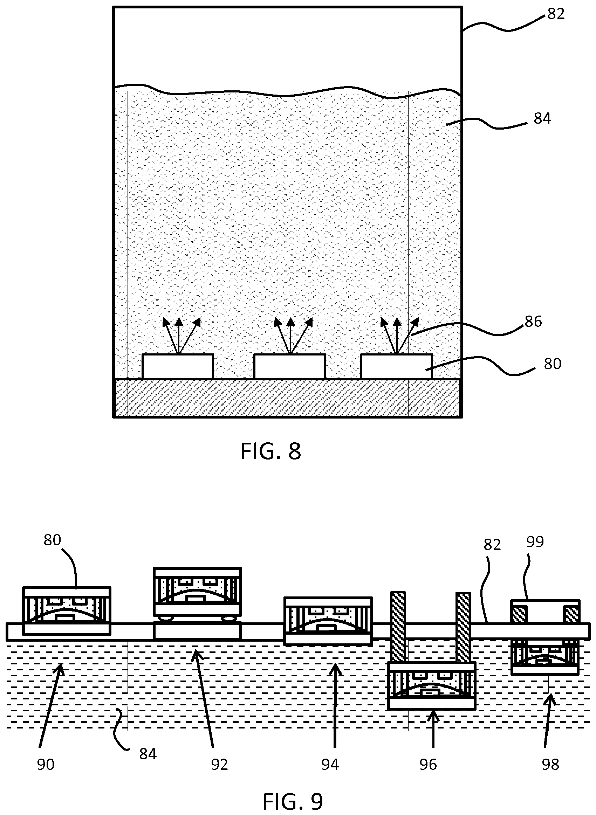

Figure 8 shows one example of a water purification device comprising a vessel 82 for containing a body of water 84 to be purified, and comprises a plurality of UV-C LED packages 80 in accordance with the examples described above, disposed within or mounted outside the vessel, for the administering to the contained water, doses of UV light.

Figure 8 shows a simple example of such an embodiment, wherein the vessel 82 houses multiple packages 80 for the delivery to the water of a dosage of UV-C light 86. In the example shown, the packages are mounted to a base supporting structure of the device, and disposed within the walls of the vessel, submerged within the body of water to be purified. In other examples however, the LED modules might not be submerged, but rather disposed within or just outside the walls of the vessel, for example. The walls may in this case comprise a UV-transparent material, such that light from the modules may penetrate into the contained water, but without making fluid contact with the water.

There may be additional supporting structures for angling the UV LEDs to generate light at a particular range of propagation angles. The assemblies might additionally comprise optical or other beam-shaping elements.

Many integration methods are thus possible, and Figure 9 shows some possibilities. One wall of the vessel 82 is shown, with five different ways to integrate the package 80 into the wall.

In the arrangement 90, the exit window of the package is recessed into the outer wall of the vessel, providing close thermal coupling with the water 84 inside the vessel.

In the arrangement 92, the package is mounted over a transparent portion (transparent to UV) of the vessel wall, with thermal coupling between the exit window of the package and the transparent portion of the outer wall of the vessel.

In the arrangement 94, the package is sealed into an opening through the outer wall so that the exit window is fully or nearly full submerged.

In the arrangement 96, the package is fully submerged and electrical connections extend through the outer wall. The package may seat against the inside of the outer wall so the arrangement is then similar to Figure 8.

In the arrangement 98, the package is fully submerged but seated against the inside of the outer wall. Instead of passing connections through the outer wall, there is wireless power transfer (e.g. inductive coupling) from a power transfer module 99 mounted outside the vessel.

The packages may be used in a hand-held, or otherwise portable purification device, comprising a plurality of UV-C LED packages as described above. The portable device might, for example, be adapted for manual insertion into any desired water-containing vessel, upon which the UV LED package or assembly of packages- are stimulated to deliver a desired dose of UV-C radiation to the contained water.

The invention is described above in connection with a use within a UV package for use in water hygiene applications. However the invention may be used in other applications. In any application where a partitioning of the thermal management to multiple levels, so making use of 3D thermal management, is of interest, the invention may be applied.

The invention may be applied to UV LEDs other than UV-C LEDs, for example to UV-A or UV-B LEDs.

Other variations to the disclosed embodiments can be understood and effected by those skilled in the art in practising the claimed invention, from a study of the drawings, the disclosure, and the appended claims. In the claims, the word "comprising" does not exclude other elements or steps, and the indefinite article "a" or "an" does not exclude a plurality.

## Claims

1. A solid state UV output device package, comprising:
a base (22) comprising a chamber (24);
electrical components (26) within the chamber;
at least two spring contacts (28) mounted in the chamber; and
a lid (20),
wherein the lid comprises:
a UV transparent or translucent window (10);
electrical connection tracks (12) mounted over the inside of the window; and
a solid state UV output device (14) mounted over the electrical connection tracks,
wherein the lid (20) is mounted over the base (22) to close the chamber (24), with the electrical connection tracks making electrical contact with the spring contacts, and wherein the solid state UV output device and the electrical components are provided on different levels.

2. A solid state UV output device package as claimed in claim 1, wherein the electrical components (26) comprise or form part of a driver circuit for the solid state UV output device.

3. A solid state UV output device package as claimed in claim 1 or 2, wherein the UV output device (14) comprises a UV LED arrangement

4. A solid state UV output device package as claimed in claim 3, wherein the UV LED arrangement comprises one or more UV-C LEDs.

5. A solid state UV output device package as claimed in any preceding claim, wherein the chamber is UV reflective.

6. A solid state UV output device package as claimed in claim 5, further comprising a UV reflecting material (40) within the chamber.

7. A solid state UV output device package as claimed in claim 6, wherein the UV reflecting material (40) forms a focusing mirror shape within the chamber.

8. A solid state UV output device package as claimed in any preceding claim, wherein the base comprises (22) a printed circuit board (29) on which at least some of the electrical components (26) are mounted.

9. A solid state UV output device package as claimed in any preceding claim, wherein the base comprises anodized aluminum side walls (25).

10. A solid state UV output device package as claimed in any preceding claim, comprising thermal coupling elements between the base and the lid.

11. A solid state UV output device package as claimed in any preceding claim, wherein the UV transparent window (10) comprises a translucent ceramic.

12. A solid state UV output device package as claimed in any preceding claim, wherein the UV transparent window comprises beam shaping optics.

13. A water purification module for administering UV light to a body of water, comprising a solid state UV output device package as claimed in any preceding claim.

## Patentansprüche

1. Festkörper-UV-emittierende Vorrichtungsverpackung, umfassend:
eine Basis (22), die eine Kammer (24) umfasst;
elektrische Komponenten (26) innerhalb der Kammer;
mindestens zwei Federkontakte (28), die in der Kammer angebracht sind; und
einen Deckel (20),
wobei der Deckel Folgendes umfasst:
ein UV-transparentes oder lichtdurchlässiges Fenster (10);
elektrische Verbindungsbahnen (12), die über der Innenseite des Fensters angebracht sind; und
eine Festkörper-UV-emittierende Vorrichtung (14), die über den elektrischen Verbindungsbahnen angebracht ist,
wobei der Deckel (20) über der Basis (22) angebracht ist, um die Kammer (24) zu schließen, wobei die elektrischen Verbindungsbahnen einen elektrischen Kontakt mit den Federkontakten herstellen, und wobei die Festkörper-UV-emittierende Vorrichtung und die elektrischen Komponenten auf verschiedenen Ebenen bereitstellt sind.

2. Festkörper-UV-emittierende Vorrichtungsverpackung nach Anspruch 1, wobei die elektrischen Komponenten (26) eine Treiberschaltung für die Festkörper-UV-emittierende Vorrichtung umfassen oder einen Teil davon bilden

3. Festkörper-UV-emittierende Vorrichtungsverpackung nach Anspruch 1 oder 2, wobei die UV-emittierende Vorrichtung (14) eine UV-LED-Anordnung umfasst.

4. Festkörper-UV-emittierende Vorrichtungsverpackung nach Anspruch 3, wobei die UV-LED-Anordnung eine oder mehrere UV-C-LEDs umfasst.

5. Festkörper-UV-emittierende Vorrichtungsverpackung nach einem der vorstehenden Ansprüche, wobei die Kammer UV-reflektierend ist.

6. Festkörper-UV-emittierende Vorrichtungsverpackung nach Anspruch 5, ferner umfassend ein UV-reflektierendes Material (40) innerhalb der Kammer.

7. Festkörper-UV-emittierende Vorrichtungsverpackung nach Anspruch 6, wobei das UV-reflektierende Material (40) eine Fokussierspiegelform innerhalb der Kammer bildet.

8. Festkörper-UV-emittierende Vorrichtungsverpackung nach einem der vorstehenden Ansprüche, wobei die Basis (22) eine Leiterplatte (29) umfasst, auf der mindestens einige der elektrischen Komponenten (26) angebracht sind.

9. Festkörper-UV-emittierende Vorrichtungsverpackung nach einem der vorstehenden Ansprüche, wobei die Basis eloxierte Aluminium-Seitenwände (25) umfasst.

10. Festkörper-UV-emittierende Vorrichtungsverpackung nach einem der vorstehenden Ansprüche, umfassend thermische Kopplungselemente zwischen der Basis und dem Deckel.

11. Festkörper-UV-emittierende Vorrichtungsverpackung nach einem der vorstehenden Ansprüche, wobei das UV-transparente Fenster (10) eine lichtdurchlässige Keramik umfasst.

12. Festkörper-UV-emittierende Vorrichtungsverpackung nach einem der vorstehenden Ansprüche, wobei das UV-transparente Fenster eine Strahlformungsoptik umfasst.

13. Wasserreinigungsmodul für eine Festkörper-UV-emittierende Vorrichtung zum Verabreichen von UV-Licht an einen Wasserkörper, umfassend eine Festkörper-UV-emittierende Vorrichtungsverpackung nach einem der vorstehenden Ansprüche.

## Revendications

1. Ensemble dispositif émetteur d'UV à semi-conducteurs, comprenant :
une base (22) comprenant une chambre (24) ;
des composants électriques (26) dans la chambre ;
au moins deux contacts à ressort (28) fixés dans la chambre ; et
un couvercle (20),
dans lequel le couvercle comprend :
une fenêtre transparente ou translucide (10) aux UV ;
des pistes de connexion électriques (12) fixées sur la partie intérieure de la fenêtre ; et
un dispositif émetteur d'UV à semi-conducteurs (14) fixé sur les pistes de connexion électriques,
dans lequel le couvercle (20) est fixé sur la base (22) pour fermer la chambre (24), les pistes de connexion électriques étant en contact électrique avec les contacts à ressort, et dans lequel le dispositif émetteur d'UV à semi-conducteurs et les composants électrique sont prévus à différents niveaux.

2. Ensemble dispositif émetteur d'UV à semi-conducteurs selon la revendication 1, dans lequel les composants électriques (26) comprennent un circuit de commande du dispositif émetteur d'UV à semi-conducteurs ou en font partie.

3. Ensemble dispositif émetteur d'UV à semi-conducteurs selon les revendications 1 ou 2, dans lequel le dispositif émetteur d'UV à semi-conducteurs (14) comprend un agencement de DEL à UV.

4. Ensemble dispositif émetteur d'UV à semi-conducteurs selon la revendication 3, dans lequel l'agencement de DEL à UV comprend une ou plusieurs DEL à UV-C.

5. Ensemble dispositif émetteur d'UV à semi-conducteurs selon l'une quelconque des revendications précédentes, dans lequel la chambre réfléchit les UV.

6. Ensemble dispositif émetteur d'UV à semi-conducteurs selon la revendication 5, comprenant en outre un matériau réfléchissant les UV (40) dans la chambre.

7. Ensemble dispositif émetteur d'UV à semi-conducteurs selon la revendication 6, dans lequel le matériau réfléchissant les UV (40) a la forme d'un miroir de focalisation dans la chambre.

8. Ensemble dispositif émetteur d'UV à semi-conducteurs selon l'une quelconque des revendications précédentes, dans lequel la base (22) comprend une carte de circuit imprimé (29) sur laquelle sont fixés au moins une partie des composants électriques (26).

9. Ensemble dispositif émetteur d'UV à semi-conducteurs selon l'une quelconque des revendications précédentes, dans lequel la base comprend des parois latérales d'aluminium anodisé (25).

10. Ensemble dispositif émetteur d'UV à semi-conducteurs selon l'une quelconque des revendications précédentes, comprenant des éléments de couplage thermique entre la base et le couvercle.

11. Ensemble dispositif émetteur d'UV à semi-conducteurs selon l'une quelconque des revendications précédentes, dans lequel la fenêtre transparente aux UV (10) comprend une céramique translucide.

12. Ensemble dispositif émetteur d'UV à semi-conducteurs selon l'une quelconque des revendications précédentes, dans lequel la fenêtre transparente aux UV comprend une optique de formation de faisceau.

13. Module de purification d'eau permettant d'administrer une lumière UV à une étendue d'eau, comprenant un ensemble dispositif émetteur d'UV à semi-conducteurs selon l'une quelconque des revendications précédentes.
